**Europäisches Patentamt**

**European Patent Office**

**Office européen des brevets**

(19)

(11) Veröffentlichungsnummer: **0 005 744**
**B1**

(12)

# EUROPÄISCHE PATENTSCHRIFT

(45) Veröffentlichungstag der Patentschrift:
23.09.81

(21) Anmeldenummer: 79101387.3

(22) Anmeldetag: 07.05.79

(51) Int. Cl.³: **C 30 B 25/10**, H 01 L 21/205

(54) **Verfahren zum Aufwachsen von Epitaxieschichten auf selektiv hochdotierten Siliciumsubstraten.**

(30) Priorität: 05.06.78 US 912660

(43) Veröffentlichungstag der Anmeldung:
12.12.79 Patentblatt 79/25

(45) Bekanntmachung des Hinweises auf die Patenterteilung:
23.09.81 Patentblatt 81/38

(84) Benannte Vertragsstaaten:
DE FR GB

(56) Entgegenhaltungen:
BE-A-625 516
DE-A-1 419 717
DE-B-1 225 617
DE-B-1 249 229

(73) Patentinhaber: International Business Machines
Corporation, Armonk, N.Y. 10504 (US)

(72) Erfinder: Srinivasan, Gurumakonda Ramaswamiengar,
165 Mark Vincent Drive, Poughkeepsie New
York 12 603 (US)

(74) Vertreter: Oechssler, Dietrich, Dr.rer.nat. Dipl.-Chem.,
Schönaicher Strasse 220, D-7030 Böblingen (DE)

EP 0 005 744 B1

**0 005 744**

## Verfahren zum Aufwachsen von Epitaxieschichten auf selektiv hochdotierten Siliciumsubstraten

Die Erfindung betrifft ein Verfahren, welches im Oberbegriff des Anspruchs 1 definiert ist.

Mit dem Trend zu immer höherer Integration bei integrierten Halbleiterschaltungen erhöht sich auch das Bedürfnis nach flachen Bauelementstrukturen. Unter »flach« sind in diesem Zusammenhang Strukturen zu verstehen, welche sich bis in eine Tiefe unter der Halbleiteroberfläche von weniger als 1 $\mu$m erstrecken. In solchen Halbleiterbauelement-Strukturen wurden Epitaxieschichten gebraucht, welche $\leqslant$ 2 $\mu$m dick sind. Die konventionelle Technik erlaubt nicht die Verwendung solch dünner Epitaxieschichten, weil die Ausdiffusion aus dotierten Bereichen im Substrat, welche vor dem Aufwachsen der Epitaxieschicht erzeugt worden sind, eine Dotierung der Epitaxieschicht zur Folge hat, welches sich bis zu einer Höhe von ungefähr 1 $\mu$m (gemessen von der Substratoberfläche aus) in die Epitaxieschicht hinein erstreckt.

Dieses Problem ist in dem Artikel »Autodoping Effect of Antimony-Arsenic Simultaneous Diffusion in Silicon« von Y. Tsunoda, im Japan J. Appl. Phys., Band 16, Nr. 8, Seiten 1483, 1484 (1977) angesprochen. Diese starke Ausdiffusion ist auf die hohe Temperatur, welche beim Aufwachsen von aus Silicium bestehenden Epitaxieschichten angewandt werden, und welche typischerweise im Bereich zwischen 1150 und 1200° C liegen, zurückzuführen. Temperaturen, welche unter 1150° C liegen, werden beim Aufwachsen von Epitaxieschichten aus Silicium deshalb nicht angewandt, weil sich die Qualität der Epitaxieschichten bei niedrigen Aufwachstemperaturen stark verschlechtert. Besonders gilt dies dann, wenn im Substrat hochdotierte Bereiche vorhanden sind.

Es sind Versuche bekanntgeworden, um Epitaxieschichten aus Silicium bei niedrigen Temperaturen, beispielsweise bei 1000° C, aufzuwachsen. So wird im US-Patent 3 189 494 eine Methode beschrieben, bei der zunächst auf einem Substrat bei sehr hohen Temperaturen im Bereich zwischen 1250 und 1360° C eine 0,1 $\mu$m dicke Epitaxieschicht aufgewachsen wird, bei der dann die Abscheidungstemperatur auf eine Temperatur, welche nicht niedriger als 1000° C liegt, reduziert wird und dann bei dieser Temperatur die Epitaxieschicht bis zur gewünschten Dicke weiter aufgewachsen wird. Dieses Verfahren hat aus zwei Gründen keinen Eingang in die Technik der Herstellung moderner Hochleistungsbauelemente gefunden. Einerseits verursachte nämlich die anfänglich sehr hohe Aufwachstemperatur eine übermäßige Verarmung der dotierten Bereiche im Substrat an Dotierungsmaterial und andererseits verschlechtert sich die Qualität der Epitaxieschicht aufgrund von Diffusionsspitzen und weil bei diesen übermäßig hohen Temperaturen Verunreinigungen aus den Plättchenhalter und dem Quarzmaterial heraus verdampfen und dann in die aufwachsende Epitaxieschicht eingebaut werden.

Eine andere Technik ist der Zwei-Schritt-Prozeß, welcher von T. Ishii in dem Artikel »Silicon Epitaxial Wafer with Abrupt Interface by Two-Step Epitaxial Growth Technique«, welcher im Journal of the Electrochemical Soc., Band 122, November 1975, Seiten 1523 bis 1531 und in dem Artikel »The Effect of Vapor Etching on ›Diffuse-Up‹ of Buried Impurities into Epitaxial Layer«, welcher im Japan Journal Appl. Phys., Band 13, 1974, Nr. 11, Seiten 1903, 1904, erschienen ist, beschrieben. Die genannte Methode verwendet Silan-Gas als Quellmaterial für das Aufwachsen der Epitaxieschicht. Um eine übermäßige Anzahl von Defekten zu vermeiden, wird vor dem Aufwachsen der Epitaxieschicht das Substrat einer Ätzung in Chlorwasserstoff(HCl)-Dampf bei einer hohen Temperatur, beispielsweise bei 1200° C, unterworfen. Obwohl die HCl-Ätzung etwas hilft, die Anzahl von Defekten zu reduzieren, führt der HCl-Dampf weitere Komplikationen in das Verfahren ein. Zu den Faktoren, welche diese Verunreinigungen verursachen, gehören die Verunreinigungen, welche in dem HCl-Gas selbst enthalten sind, die Freisetzung von Verunreinigungen aus anderen Teilen des Reaktors aufgrund des HCl-Ätzens, die Bildung eines submikroskopischen Niederschlags an der Grenzfläche zwischen Substrat und Epitaxieschicht, eine verstärkte Musterverschiebung und eine Verschlechterung der Musterqualität. Aus diesen und anderen Gründen ist die epitaxiale Aufwachstechnik unter Verwendung von Silan nicht geeignet, um integrierte Schaltungen höchster Leistung herzustellen.

In den US-Patenten 3 669 769 und 3 982 974 wird Siliciumtetrachlorid als Quellmaterial für Silicium beim Aufwachsen von Epitaxieschichten auf Siliciumsubstraten angegeben. In dem US-Patent 3 982 974 wird bei der Beschreibung des Standes der Technik (siehe Spalte 2 Zeile 19 bis 26) auf ein bekanntes Verfahren hingewiesen, welches das Selbstdotierungsproblem durch eine Erniedrigung der Abscheidungstemperatur zu lösen versuchte. Dadurch sollte die Ausdiffusion der Dotierungsverunreinigung in das Gas während des Aufwachsens auf ein Minimum reduziert werden. Obwohl die Erniedrigung der Abscheidungstemperatur den Selbstdotierungseffekt etwas reduzierte, war das Verfahren nicht brauchbar, weil die dabei erzeugte Epitaxieschicht eine übermäßig große Anzahl von kristallographischen Defekten aufwies. In dem US-Patent 3 669 769 wird ein Prozeß beschrieben, bei dem vor dem Aufwachsen der Epitaxieschicht eine Wärmebehandlung bei der Temperatur, bei der nach der die epitaxiale Abscheidung erfolgt, durchgeführt wird. Der Wärmebehandlung folgt die epitaxiale Abscheidung, welche zur Überwindung des Selbstdotierungsproblems zunächst mit einer langsamen und dann mit einer schnelleren Geschwindigkeit vorgenommen wird.

Es ist die Aufgabe der Erfindung, ein einfaches, in einer fabrikmäßigen Fertigung einsetzbares

2

Verfahren zum reproduzierbaren Herstellen von Epitaxieschichten aus Silicium auf Siliciumsubstraten anzugeben, bei dem die Ausdiffusion aus hochdotierten Substratbereichen in die aufwachsende Epitaxieschicht und die Selbstdotierung der Epitaxieschicht außerhalb der Bereiche über den hochdotierten Substratbereichen gering ist, und bei dessen Anwendung die fertigen Epitaxieschichten eine geringe Anzahl von elektrisch aktiven Defekten enthalten.

Diese Aufgabe wird mit einem Verfahren der eingangs genannten Art mit den Merkmalen des kennzeichnenden Teils des Anspruchs 1 gelöst.

Das erfindungsgemäße Verfahren vermeidet das Ätzen mit Chlorwasserstoffdampf und die Anwendung von Silan, weshalb die damit verbundenen unerwünschten Effekte nicht auftreten. Bei dem erfindungsgemäßen Verfahren wird Siliciumtetrachlorid, $SiCl_4$, bei niedrigen Temperaturen als Siliciumquelle eingesetzt, obwohl bis dahin allgemein die Ansicht bestand, daß die Qualität und Epitaxieschichten, welche unter Verwendung von $SiCl_4$ bei niedrigen Temperaturen aufgewachsen worden sind, sehr schlecht ist. Die guten Ergebnisse, welche mit dem erfindungsgemäßen Verfahren erzielt werden, beruhen darauf, daß die Substrate zunächst auf eine relativ hohe Temperatur erhitzt werden und dann bei einer relativ niedrigen Temperatur die Epitaxieschicht aufgewachsen wird.

Es ist vorteilhaft, wenn das Erhitzen vor dem Aufwachsen zwischen etwa 4 und etwa 35 Minuten dauert, wobei die genaue Zeitdauer entsprechend der gewählten Erhitzungstemperatur festgelegt wird. Das Erhitzen erfolgt am besten direkt in dem Reaktor, in welchem auch das Aufwachsen stattfindet. Dadurch wird das Verfahren sehr einfach, denn man muß dann nach dem Erhitzen lediglich die Temperatur auf die Abscheidungstemperatur absenken und dem während des Erhitzens über die Substrate fließenden Wasserstoffstrom eine festgelegte Menge von $SiCl_4$ und u. U. ein Dotierungsmaterial zumischen. Unter diesen Bedingungen fängt dann die Epitaxieschicht an aufzuwachsen, und dieser Vorgang wird so lange fortgesetzt, bis die gewünschte Dicke der Epitaxieschicht erreicht ist.

Um eine geringe Selbstdotierung, eine geringe Musterverschiebung und eine gute Dickenkontrolle sicherzustellen, ist es wünschenswert, die Wachstumsrate der Epitaxieschicht so niedrig zu halten, wie es praktische Gesichtspunkte zulassen. Ein vorteilhafter Bereich der Wachstumsgeschwindigkeit liegt zwischen ungefähr 0,05 und ungefähr 0,2 μm pro Minute.

Das erfindungsgemäße Verfahren entkoppelt die drei Faktoren, welche bisher die Brauchbarkeit von Epitaxieverfahren begrenzt haben. Diese Faktoren sind: das Ausmaß der Ausdiffusion von Dotierungsverunreinigungen aus dem Substrat, die Anzahl von elektrisch aktiven Defekten in den aufgewachsenen Epitaxieschichten und das Ausmaß der Selbstdotierung. Bei den bekannten Verfahren beeinflussen sich diese Faktoren derart, daß die Verbesserung eines der Faktoren, die Verschlechterung der beiden anderen zur Folge hat, so daß die bekannten Verfahren nur dann einigermaßen brauchbar sind, wenn ein optimaler Ausgleich zwischen diesen Faktoren gefunden wird. Da in dem erfindungsgemäßen Verfahren diese Faktoren entkoppelt sind, kann jeder Faktor für sich optimiert werden, so daß es mit dem erfindungsgemäßen Verfahren möglich ist, Epitaxieschichten aufzuwachsen, welche wesentlich bessere Eigenschaften im Hinblick auf ihre Verwendung in integrierten Halbleiterbauelementen haben, als die gemäß den bekannten Verfahren erzeugten Epitaxieschichten. Das erfindungsgemäße Verfahren macht es möglich:

1. daß die Ausdiffusion aus beispielsweise mit Arsen N+-dotierten Halbleiterbereichen von einem typischen Wert von 0,9 μm auf ungefähr 0,2 μm reduziert wird,
2. daß die Selbstdotierung aus beispielsweise mit Arsen N+-dotierten Halbleiterbereichen gegenüber den üblichen Werten um eine Größenordnung reduziert wird,
3. daß die Ausdiffusion und die Selbstdotierung beim Vorliegen von P-dotierten Bereichen im Substrat wesentlich reduziert wird,
4. daß die Anzahl der elektrisch aktiven Defekte gegenüber den üblichen Werten um mehr als eine Größenordnung reduziert wird und
5. daß die MOS-Leckstromeigenschaften wesentlich verbessert (eine 50fache Erniedrigung der üblicherweise gemessenen Leckströme wird erreicht) werden.

Bisher sind niemals alle diese Vorteile gleichzeitig erreicht worden und das erfindungsgemäße Verfahren erlaubt es deshalb, Epitaxieschichten mit einer Dicke kleiner ungefähr 2 μm, welche für die Verwendung in sehr hoch integrierten Schaltkreisen brauchbar sind, aufzuwachsen.

Weitere vorteilhafte Ausgestaltungen des erfindungsgemäßen Verfahrens ergeben sich aus den Unteransprüchen.

Die Erfindung wird anhand von durch Zeichnungen erläuterten Ausführungsbeispielen beschrieben. Es zeigt

Fig. 1 vertikale Dotierungsprofile, welche mittels Messungen des Ausbreitungswiderstandes ermittelt wurden, von Epitaxieschichten auf Substraten, welche dort, wo das Profil aufgenommen worden ist, ein Subkollektorgebiet aufweisen,

Fig. 2 vertikale Dotierungsprofile, welche mittels Ausbreitungswiderstandsmessungen ermittelt worden sind, von Epitaxieschichten auf Substraten, welche Subkollektorgebiete aufweisen, wobei jedoch die Profile außerhalb der Bereiche, unter welchen Subkollektorgebiete vorhanden sind, aufgenommen worden sind und deshalb nur von der lateralen Selbstdotierung beeinflußt sind,

Fig. 3 in einem Diagramm die Anzahl der elektrisch aktiven Defekte in gemäß dem Stand der Technik und gemäß der Erfindung auf Substraten, welche keinen vergrabenen dotierten Schichten aufweisen, aufgewachsenen Epitaxieschichten in Abhängigkeit von der Aufwachstemperatur und

Fig. 4 in einem Diagramm die MOS-Leckströme in gemäß dem Stand der Technik und gemäß der Erfindung auf Substraten, welche keine vergrabenen, dotierten Schichten aufweisen, aufgewachsenen Epitaxieschichten in Abhängigkeit von der Aufwachstemperatur.

Die Herstellung von hochintegrierten Bipolarbauelementen beginnt mit der Bildung von vergrabenen Schichten im Siliciumsubstrat. Diese vergrabenen Schichten dienen im fertigen Bauelement im allgemeinen als Subkollektor, sie können aber auch als Subemitter in einer inversen Bauelementstruktur dienen. Der nächste größere Schritt besteht darin, eine sehr dünne Epitaxieschicht, d. h. eine solche, die ein bis zwei µm oder weniger dick ist, auf der Oberfläche des Siliciumsubstrats, in welchem sich die Subkollektorbereiche befinden, herzustellen. Die Qualität der fertigen bipolaren Bauelemente hängt sehr stark von der Bildung dieser dünnen Epitaxieschicht ab.

Es ist wichtig, den Selbstdotierungseffekt auf ein Minimum zu reduzieren. Eine Erniedrigung der Abscheidungstemperatur mit dem Ziel, die Ausdiffusion zu begrenzen, hat eine Zunahme der lateralen Selbstdotierung, d. h. eine Selbstdotierung außerhalb der Bereiche über den Kollektoren zur Folge. Diese Zunahme der lateralen Selbstdotierung beruht auf einer Geschwindigkeitsbedingung (rate limitation), welche durch die Temperaturabhängigkeit der Geschwindigkeit, mit der die Verunreinigungen eingebaut werden, bestimmt ist. Experimente haben gezeigt, daß eine Abscheidungstemperatur unterhalb 1000° C sowohl bezüglich des lateralen Selbstdotierens als auch bezüglich der Qualität der epitaxialen Struktur nicht attraktiv wäre. Die obere Grenze liegt bei etwa 1100° C, weil oberhalb dieser Temperatur die Ausdiffusion unannehmbar hoch ist. Es ist auch gefunden worden, daß eine Abnahme der Wachstumsgeschwindigkeit eine Abnahme der lateralen Selbstdotierung zur Folge hat und daß bei Wachstumsgeschwindigkeiten zwischen ungefähr 0,05 und 0,2 µm/min die Selbstdotierungsreaktionen so nahe am thermodynamischen Gleichgewicht sind, daß eine weitere Abnahme der Wachstumsgeschwindigkeit die laterale Selbstdotierung nicht wesentlich erniedrigt. Die untere Grenze von 0,05 µm/min stellt eine praktische Grenze dar, unterhalb der es übermäßig lang dauert, um eine Epitaxieschicht von ungefähr 1 µm Dicke abzuscheiden. Die Wachstumsgeschwindigkeit oberhalb 0,2 µm/min bringt einen Verunreinigungseinfangmechanismus mit sich, welcher die Selbstdotierung vergrößert. Zusätzlich ist bei sonst identischen Aufwachsbedingungen die Selbstdotierung in einem $SiCl_4$-System niedriger als in einem Silan-System.

Die Qualität der Epitaxieschicht ist unter anderem abhängig von der Qualität des Substrats zur Zeit des Abscheidens. Bei Verfahren, bei denen eine gute Qualität der Substratoberfläche gerade dann, wenn die Abscheidung beginnt, sichergestellt ist, sind besser als solche Verfahren, bei denen das nicht der Fall ist. Substratoberflächen guter Qualität werden erreicht, indem das Plättchen kurz vor dem Aufwachsen einer geeigneten Wärmebehandlung unterworfen wird.

Bei der Bildung einer typischen, mit Arsen dotierten Subkollektorschicht, erhält man eine Oberflächenkonzentration ($C_0$) von $\geq$ ungefähr $1,5 \times 10^{21}$ Atomen/cm³. Es ist sichergestellt, daß eine Schicht mit einer hohen Oberflächenkonzentration elektrisch aktive Defekte in der Epitaxieschicht mitverursacht. Es wird angenommen, daß die Ursache die Bildung von Diffusionsspitzen aus Arsen oberhalb der Subkollektoren ist. Darüber hinaus ist es bekannt, daß zwischen der Selbstdotierung und der Oberflächenkonzentration $C_0$ eine derartige Beziehung besteht, daß die Selbstdotierung mit abnehmendem $C_0$ abnimmt. Eine Untersuchung der Wirkung der Wärmebehandlung vor dem Aufwachsen der Epitaxieschicht auf die Selbstdotierung zeigt eine direkte Korrelation zwischen der Zeit und der Temperatur der Wärmebehandlung und dem Ausmaß der lateralen Selbstdotierung und der Dichte der elektrisch aktiven Defekte in der Epitaxieschicht. Es ist gefunden worden, daß die Wirkungen der Wärmebehandlung quantitativ als Folge der temperaturabhängigen Arsenverdampfung während der Wärmebehandlung vor dem Aufwachsen der Epitaxieschicht und der daraus folgenden Verarmung der Arsenquelle, d. h. der Verarmung der Substratoberfläche an Arsen, verstanden werden kann. Die Verarmung der Subkollektorquelle, kurz bvor die Epitaxieschicht aufgewachsen wird, ist sowohl vorteilhaft bezüglich der Selbstdotierung als auch bezüglich der Qualität der Schichtstruktur. Voraussetzung dafür ist allerdings, daß diese Verarmung nicht übermäßig groß ist, weil die hohe Leitfähigkeit der vergrabenen Schicht aufrechterhalten werden muß.

Die hohe Oberflächenkonzentration in den Subkollektorschichten ist auch das Ergebnis einer Anhäufung der Dotierungsverunreinigung im Silicium an der Grenzfläche zwischen dem Silicium (Si) und dem Siliciumdioxid ($SiO_2$), welche sich während des Eintreibens unter Oxidationsbedingungen bildet. Ein wesentlicher Anteil der Dotierungsverunreinigung befindet sich in einer mehrere hundert nm dicken Schicht direkt an Substratoberfläche und ein großer Teil dieser Dotierungsverunreinigung ist elektrisch inaktiv. Die Entfernung des elektrisch inaktiven Arsens von der obersten Schicht des Substrats vor dem Aufwachsen der Epitaxieschicht sollte sich günstig auf den Prozeß auswirken, ohne daß sich dabei der Flächenwiderstand der Subkollektoren wesentlich erhöht.

Auf der Basis der obigen Betrachtungen wird bei dem erfindungsgemäßen Verfahren vor dem Aufwachsen der Epitaxieschicht eine Wärmebehandlung durchgeführt. Die Auswertung unserer Wärmebehandlungsdaten zeigte, daß man die maximale Konzentration außerhalb der Bereiche über den Subkollektorgebieten um fast eine Größenordnung reduzieren konnte, indem das Substrat bei Temperaturen im Bereich zwischen 1120 und 1180° C ungefähr 4 bis 35 Minuten lang, wobei die Dauer von der gewählten Temperatur abhängt, wärmebehandelt wurde, bevor die Epitaxieschicht bei einer niedrigeren Temperatur aufgewachsen wurde. Eine Wärmebehandlungstemperatur oberhalb 1180° C ist nicht attraktiv, da eine Wärmebehandlung bei 1200° C, welcher einer Abscheidung bei 1000° C folgte, eine schlechte Qualität der Epitaxieschicht zur Folge hatte. Eine Temperatur unterhalb 1120° C ist deshalb nicht günstig, weil eine übermäßig lange Wärmebehandlung notwendig ist, um eine ähnliche Reduktion der Selbstdotierng zu erreichen, wie wenn bei einer Temperatur in dem angegebenen Bereich erhitzt wird. Diese auf eine Wärmebehandlung bei Temperaturen oberhalb 1180° C zurückzuführende Verschlechterung der Qualität der Epitaxieschichtstruktur ist angesichts der beschleunigten Verdampfung und der ätzenden Wirkung von Wasserstoff auf Silicium bei diesen hohen Temperaturen nicht überraschend.

Die folgenden Beispiele sollen helfen, die Erfindung besser zu verstehen; es sei aber klargestellt, daß das erfindungsgemäße Verfahren nicht nur unter den in den Beispielen angegebenen Bedingungen durchgeführt werden kann.

Beispiele 1, 2 und 3

Die Epitaxieschichten wurden auf runde Substrate aufgewachsen, welche einen Durchmesser von ungefähr 57,1 mm hatten, welche aus P-dotiertem Silicium bestanden und deren Oberfläche eine (100-)Orientierung hatte. Die Siliciumplättchen hatten eine Arsensubkollektordiffusion hinter sich, welcher 62% der Plättchenoberfläche ausgesetzt worden waren. Die Arsenoberflächenkonzentration $(C_0)$ in den Subkollektorgebieten lag bei ungefähr $1,5 \times 10^{21}$ Atomen/cm$^3$. Die Bedingungen, unter welchen in jedem Beispiel prozessiert wurde, sind in der Tabelle 1 aufgeführt.

Tabelle I

|  | Beispiele | | |
|---|---|---|---|
|  | 1 | 2 | 3 |
| Quellmaterial | SiCl$_4$ | SiCl$_4$ | SiCl$_4$ |
| Wärmebehandlung vor Epitaxie | 1150°C 10 Min. Lang | 1050°C 10 Min. lang | keine |
| Abscheidungstemperatur | 1050°C | 1050°C | 1150°C |
| Wachstumsgeschwindigkeit (μm/Min.) | 0,08 | 0,08 | 0,08 |
| H$_2$-Fluß (Liter/Min.) | 20,6 | 20,6 | 20,6 |
| Lineare H$_2$-Fließgeschwindigkeit (cm/sek.) | (10,5) | (10,5) | (10,5) |

Bei allen epitaxialen Abscheidungen wurde dem Reaktionsgas von außen kein Dotierungsmaterial zugegeben. Die epitaxialen Abscheidungen wurden in einem hochfrequenzbeheizten horizontalen Reaktor vorgenommen, wobei die Siliciumplättchen auf einem mit Siliciumcarbid beschichteten Graphithalter, welcher mit der Horizontalen einen Winkel von 3° bildete, lagen. Der Halter war so konstruiert, daß ein minimaler radikaler Temperaturgradient über die Plättchen sichergestellt war. Der radiale Gradient $\Delta T$ über die Plättchen war $\leq 5° C$.

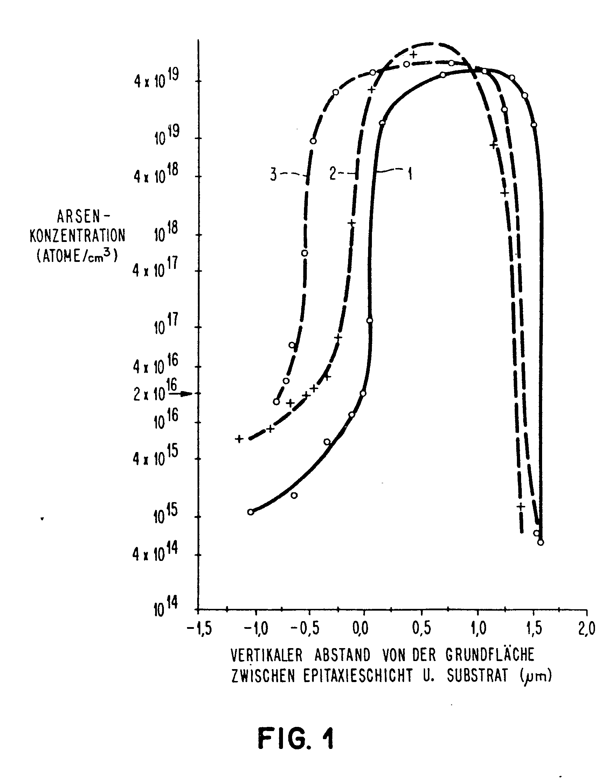

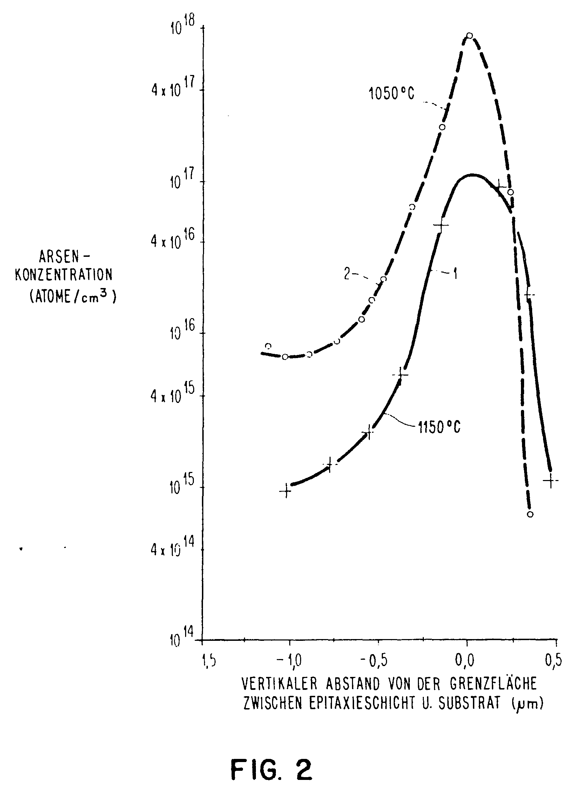

Von den fertigen Strukturen wurden die Dotierungsprofile mittels Ausbreitungswiderstandsmessungen, welche dann unter Benutzung eines existierenden APL-Programms korrigiert wurden, aufgenommen. Es wurden Profile sowohl von Stellen über den Subkollektorbereichen als auch von Stellen, welche nicht über Subkollektorbereichen lagen, ermittelt. Die Resultate sind in den Fig. 1 und 2 aufgezeichnet. Die Numerierung der Kurven (1 bis 3 bzw. 1 und 2) korrespondiert mit der Numerierung der Beispiele. Die Fig. 1 zeigt das vertikale Dotierungsprofil, d. h. das Dotierungsprofil senkrecht zur Halbleiteroberfläche, über dem Subkollektorbereich. Die Fig. 2 zeigt das vertikale Dotierungsprofil an einer Stelle, welche in horizontaler Richtung ungefähr 50 μm außerhalb des Subkollektorbereichs liegt.

0 005 744

Die Figuren zeigen, daß die Ausdiffusion $\Delta X$, welche definiert ist als der vertikale Abstand von der Grenzfläche zwischen Substrat und Epitaxieschicht, bei welchem die Arsenkonzentration auf $2 \times 10^{16}$ Atome/cm³ abgesunken ist, von einem $\Delta X$-Wert von ungefähr 0,8 μm, welcher bei einer Abscheidungstemperatur von 1150°C erhalten wird, auf einen $\Delta X$-Wert von ungefähr 0,5 μm absinkt, wenn bei 1050°C abgeschieden wird, ohne daß vorher eine Wärmebehandlung bei höherer Temperatur stattfindet. Die Ausdiffusion kann noch weiter, d. h. auf weniger als 0,1 μm reduziert werden, wenn bei 1050°C abgeschieden wird und vorher eine Wärmebehandlung bei 1150°C durchgeführt wird.

Die in der Fig. 2 gezeigten, durch Selbstdotierung verursachten Dotierungen der Epitaxieschicht außerhalb der Bereiche über den Subkollektorgebieten, werden auch, wie der Vergleich zwischen den Beispielen 1 und 2 zeigt, durch die Wärmebehandlung bei hohen Temperaturen vor dem Aufwachsen der Epitaxieschicht bezüglich der Konzentration um eine Größenordnung reduziert.

Die Qualität der Epitaxieschicht wurde sowohl mittels einer lichtoptischen Untersuchung der Oberfläche mit dem Mikroskop als auch mittels der nodischen Ätztechnik, mittels der die elektrisch aktiven Defekte in der Epitaxieschicht sichtbar gemacht werden, bestimmt. Um die Defekte in verschiedenen Tiefen der Epitaxieschicht sichtbar zu machen, wurde unter zweierlei Ätzbedingungen geätzt: Anlegung einer Spannung von 5 Volt, 5%ige Flußsäure, HF, Dauer des Ätzens 1 Min. und Anlegung einer Spannung von 2 Volt, 5%ige Flußsäure, Dauer des Ätzens 1 Min. Es wird angenommen, daß die Bedingungen beim Anlegen der 2-Volt-Spannung beim Vorliegen einer 1 μm dicken Epitaxieschicht vergleichbar sind den Bedingungen, welche beim Anlegen der 5-Volt-Spannung, um die elektrisch aktiven Defektniveaus in der dickeren (2 μm dicken) Epitaxieschicht zu messen, vorliegen.

Die epitaxiale Defektdichte $\lambda$ ist definiert als der Bruchteil von Subkollektorgebieten, mit einem oder mehr anodischen Ätzgrübchen.

Die Tabelle II zeigt einen Vergleich der Qualität der Epitaxieschichten, welche gemäß dem in Beispiel 2 angewandten Verfahren hergestellt worden sind, mit der Qualität der Epitaxieschichten, welche gemäß dem in Beispiel 1 beschriebenen Verfahren hergestellt worden sind.

Der hauptsächliche Unterschied zwischen den Beispielen 1 und 2 ist der, daß im Beispiel 1 vor dem Aufwachsen der Epitaxieschicht eine Wärmebehandlung bei 1150°C durchgeführt wird. Man ersieht aus der Tabelle II, daß, wenn bei der anodischen Ätztechnik eine Vorspannung von 2 Volt angelegt wird, bei Schichten, welche unter den Bedingungen des Beispiels 2 erzeugt worden sind, die Defektdichte (gemessen in Prozentanteilen der fehlerhaften Subkollektorgebiete) bei 10% und bei Schichten, welche unter den Bedingungen des Beispiels 1 erzeugt worden sind, die Defektdichte bei <1% liegt. Wird bei der anodischen Ätztechnik eine Vorspannung von 5 Volt angelegt, so wird bei den Schichten, welche gemäß den Bedingungen des Beispiels 2 erzeugt worden sind, eine Defektdichte von ungefähr 15% und bei Schichten, welche gemäß den Bedingungen des Beispiels 1 erzeugt worden sind, eine Defektdichte von ungefähr 1,5% gefunden. Bei beiden Spannungen wird also durch die Einführung der Wärmebehandlung bei 1150°C das Defektniveau um eine Größenordnung reduziert.

Tabelle II

| Beispiel | Defekt-Dichte (% fehlerhafte Subkollektorgebiete) | |
|---|---|---|
| | 2 V Vorspannung | 5 V Vorspannung |
| 2 | | 13,2 |
| 2 | 10,0 | 15,6 |
| 1 | 0,44 | 1,18 |
| 1 | 0,73 | 1,50 |

Beispiele 4, 5, 6 und 7

Um die Vorteile des erfindungsgemäßen Verfahrens bei seiner Anwendung auf Substrate, welche keine Subkollektordiffusion hinter sich haben, zu untersuchen, wurde ein Experiment durchgeführt, bei dem unter Flußbedingungen gearbeitet wurde, welche ähnlich denjenigen waren, welche in den Beispielen 1, 2 und 3 angewandt wurden. Auf jedem Substrat wurde bei diesen Experimenten eine 5 μm dicke, N-dotierte Epitaxieschicht mit einem spezifischen Widerstand von 1 Ωcm aufgewachsen und bei der Wärmebehandlung und beim Abscheiden wurden die in der Tabelle III angegebenen Temperaturen angewandt.

Tabelle III

| | Beispiele | | | |
|---|---|---|---|---|
| | 4 | 5 | 6 | 7 |
| Quellmaterial | $SiCl_4$ | $SiCl_4$ | $SiCl_4$ | $SiCl_4$ |
| Dotierungsstoff | As | As | As | As |
| Wärmebehandlung vor Epitaxie | 1150°C 5 Min. lang | 1150°C 5 Min. lang | 1150°C 5 Min. lang | 1150°C 5 Min. lang |
| Abscheidungstemperatur | 1000°C | 1050°C | 1100°C | 1150°C |

| | Beispiele | | |
|---|---|---|---|
| | 8 | 9 | 10 |
| Quellmaterial | $SiCl_4$ | $SiCl_4$ | $SiCl_4$ |
| Dotierungsstoff | As | As | As |
| Wärmebehandlung vor Epitaxie | 1000°C 5 Min. lang | 1050°C 5 Min. lang | 1100°C 5 Min. lang |
| Abscheidungstemperatur | 1000 °C | 1050 °C | 1100 °C |

### Beispiele 8, 9 und 10

Bei diesen Beispielen wurden unter denselben Bedingungen wie bei den Beispielen 4, 5 und 6 gearbeitet; lediglich bei der Wärmebehandlung wurde statt der Temperatur von 1150°C eine Temperatur angewandt, welche mit der bei dem jeweiligen Beispiel angewandten und aus der Tabelle III ersichtlichen Abscheidungstemperatur identisch war.

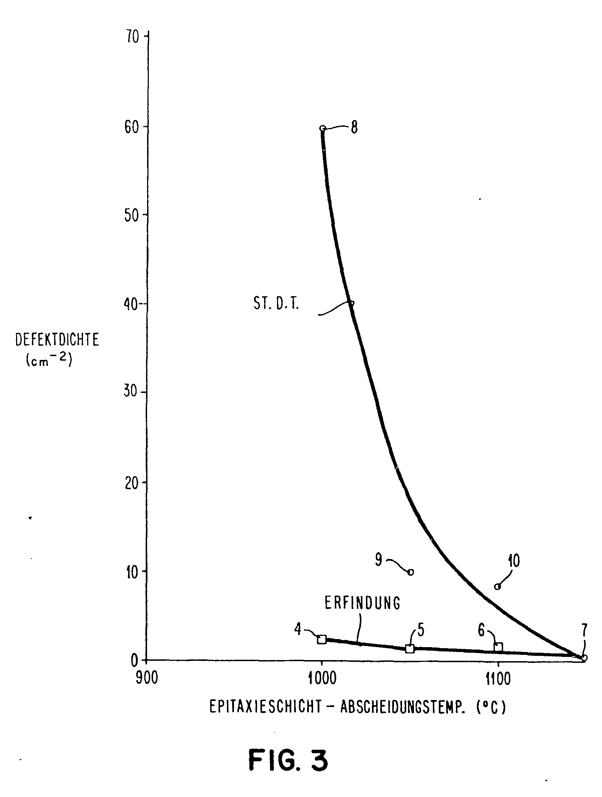

Fig. 3 zeigt die Ergebnisse einer anodischen Ätzbehandlung zur Sichtbarmachung von Defekten in Schichten, welche gemäß den Beispielen 4, 5, 6 und 7 und auch in Schichten, welche gemäß den Beispielen 8, 9 und 10, d. h. gemäß den üblichen und bekannten epitaxialen Abscheidungsverfahren hergestellt worden waren. Aus der Figur ist klar ersichtlich, daß mit dem erfindungsgemäßen Verfahren bei jeder Temperatur eine wesentlich geringere Defektdichte erreicht wird. Am bemerkenswertesten ist der Unterschied bei einer Abscheidungstemperatur von 1000°C, bei welcher beim Verfahren gemäß dem Beispiel 8 eine Defektdichte von 50 Defekten pro $cm^2$ und bei dem Verfahren gemäß dem Beispiel 4 eine Defektdichte von ungefähr 2 Defekten pro $cm^2$ erzeugt wird.

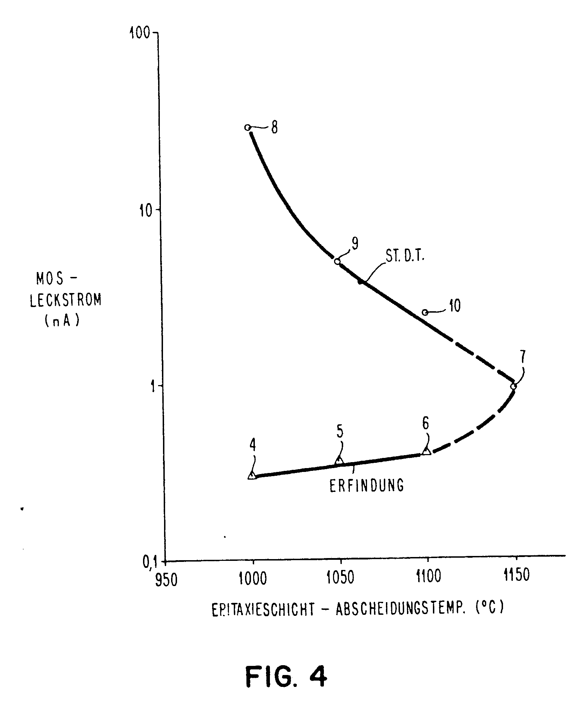

Um die MOS-Leckstromqualität der aufgewachsenen Epitaxieschichten zu überprüfen, wurden Standard-MOS-Leckstrommessungen an MOS-Punkten mit einem Durchmesser von ungefähr 1525 µm durchgeführt. Die Tabelle IV zeigt MOS-Leckstromergebnisse, welche von Proben, welche bei den Beispielen 4 bis 10 erzeugt worden sind, stammen. Pro Beispiel wurden die Leckströme an jeweils 100 MOS-Punkten auf zwei Plättchen gemessen. Bei den Proben, bei denen die Epitaxieschicht bei 1000°C abgeschieden worden ist, liegt der durchschnittliche Leckstrom bei 28,63 nA, wenn gemäß dem Beispiel 8 prozessiert worden ist, und bei 0,31 nA, wenn gemäß dem Beispiel 4, d. h. gemäß dem erfindungsgemäßen Verfahren, prozessiert worden ist. Ähnliche Verbesserungen durch das erfindungsgemäße Verfahren können bei den Proben, bei denen die Epitaxieschicht bei 1050°C bzw. bei 1100°C abgeschieden worden sind, durch den Vergleich der Beispiele 5 und 9 bzw. 6 und 10 aus der Tabelle IV festgestellt werden. Bemerkenswert ist auch der Vergleich der Anzahl von MOS-Punkten mit einem Leckstrom <0,1 nA. Bei einer Abscheidungstemperatur von 1000°C liegt diese Anzahl bei Proben, welche gemäß dem erfindungsgemäßen Prozeß (Beispiel 4) erzeugt worden sind, bei 42, während bei Proben, welche gemäß dem bekannten, üblichen Verfahren prozessiert worden sind, diese Anzahl bei Null liegt und bei einer Abscheidungstemperatur von 1050°C liegen die entsprechenden Zahlen bei 29 bzw. 0. Entsprechend erniedrigt sich die Anzahl der MOS-Punkte mit einem hohen Leckstrom (> 0,5 nA) durch die Anwendung des erfindungsgemäßen Verfahrens bei einer Abscheidungstemperatur von 1000°C von 67 auf 25, bei einer Abscheidungstemperatur von 1050°C von 73 auf 27 und bei einer Abscheidungstemperatur von 1100°C von 48 auf 6. Diese Ergebnisse sind in der Fig. 4 zusammengefaßt, in welcher die durchschnittlichen Leckströme in Abhängigkeit von der Abscheidungstemperatur einerseits für Proben, welche gemäß dem bekannten, üblichen Verfahren und andererseits für Proben, welche gemäß dem erfindungsgemäßen Verfahren prozessiert worden sind, aufgetragen sind. Die aufgrund des erfindungsgemäßen Verfahrens erzielte Qualitätsverbesserung ist bei allen in diesen Experimenten angewandten Temperaturen offensichtlich.

Tabelle IV

|  | Beispiele | | Beispiele | | Beispiele | | Beispiel |
|---|---|---|---|---|---|---|---|
|  | 8 | 4 | 9 | 5 | 10 | 6 | 7 |
| Durchschnittlicher Leckstrom ($I_L$) nA | 28,63 | 0,31 | 49,70 | 0,37 | 25,30 | 0,40 | 0,95 |
| Anzahl von MOS-Punkten mit $I_L < 0,1$ nA | 0 | 42 | 0 | 29 | 2 | 0 | 0 |
| Anzahl von MOS-Punkten mit $0,1 < I_L < 0,5$ nA | 0 | 7 | 4 | 18 | 11 | 54 | 41 |
| Anzahl von MOS-Punkten mit $I_L > 0,5$ nA | 67 | 25 | 73 | 27 | 48 | 6 | 47 |

**Patentansprüche**

1. Verfahren zum Aufwachsen von Epitaxieschichten aus Silicium auf hochdotierte Bereiche aufweisende Oberflächen von Siliciumsubstraten, dadurch gekennzeichnet, daß die Substrate zunächst bei Temperaturen im Bereich zwischen ungefähr 1120 und ungefähr 1180°C in einer Wasserstoffatmosphäre eine festgelegte Zeit erhitzt werden und anschließend die Epitaxieschicht bei Temperaturen im Bereich zwischen ungefähr 1000 und ungefähr 1100°C unter Verwendung von Siliciumtetrachlorid als Quellmaterial für das Silicium in an sich bekannter Weise aufgewachsen wird.

2. Verfahren nach Anspruch 1, dadurch gekennzeichnet, daß zwischen ungefähr 4 und ungefähr 35 Minuten lang erhitzt wird.

3. Verfahren nach Anspruch 1 oder 2, dadurch gekennzeichnet, daß auf eine Temperatur von ungefähr 1150°C erhitzt und bei einer Temperatur von ungefähr 1050°C abgeschieden wird.

4. Verfahren nach einem oder mehreren der Ansprüche 1 bis 3, dadurch gekennzeichnet, daß die Epitaxieschicht mit einer Geschwindigkeit im Bereich zwischen ungefähr 0,05 und ungefähr 0,2 µm/Min. aufgewachsen wird.

5. Verfahren nach einem oder mehreren der Ansprüche 1 bis 4, dadurch gekennzeichnet, daß als Trägergas für das Siliciumtetrachlorid Wasserstoff verwendet wird und die lineare Geschwindigkeit des $SiCl_4/H_2$-Gasflusses im Reaktor auf größer ungefähr 10 cm/sec eingestellt wird.

6. Verfahren nach einem oder mehreren der Ansprüche 1 bis 5, dadurch gekennzeichnet, daß die Epitaxieschicht auf einem Substrat mit $N^+$-dotierten Bereichen, welche eine Oberflächenkonzentration von größer ungefähr $1 \times 10^{20}$ Dotierungsatomen/cm³ haben, aufgewachsen wird.

7. Verfahren nach Anspruch 6, dadurch gekennzeichnet, daß auf einem Substrat mit Arsen-dotierten Bereichen aufgewachsen wird.

8. Verfahren nach einem oder mehreren der Ansprüche 1 bis 7, dadurch gekennzeichnet, daß dem beim Aufwachsen verwendeten Gasgemisch ein arsenhaltiges Material zugemischt wird.

**Claims**

1. Method of growing epitaxial layers of silicon on surfaces of silicon substrates with highly doped regions, characterized in that the substrates are initially heated at temperatures of between about 1120 and about 1180°C in a hydrogen atmosphere for a fixed time and subsequently the epitaxial layer is grown in a known manner at temperatures of between about 1000 and about 1100°C, using silicon tetrachloride as a source material for the silicon.

2. Method in accordance with claim 1, characterized in that heating is effected for about 4 to about 35 minutes.

3. Method in accordance with claim 1 or 2, characterized in that heating is effected to a temperature of about 1150°C and deposition is effected at a temperature of about 1050°C.

8

**0 005 744**

4. Method in accordance with any one or combination of claims 1 to 3, characterized in that the epitaxial layer is grown at a rate of between about 0.05 and about 0.2 μm/min.

5. Method in accordance with any one or combination of claims 1 to 4, characterized in that the carrier gas for the silicon tetrachloride is hydrogen and the linear velocity of the $SiCl_4/H_2$ gas flow in the reactor is greater than about 10 cm/sec.

6. Method in accordance with any one or combination of claims 1 to 5, characterized in that the epitaxial layer is grown on a substrate with $N^+$ doped regions having a surface concentration of greater than about $1 \times 10^{20}$ doping atoms/$cm^3$.

7. Method in accordance with claim 6, characterized in that growth is effected on a substrate with arsenic doped regions.

8. Method in accordance with any one or combination of claims 1 to 7, characterized in that a material containing arsenic is admixed with the gas mixture used during the growth.

**Revendications**

1. Procédé pour faire croître des couches épitaxiales de silicium ayant des régions fortement dopées, caractérisé en ce que l'on chauffe d'abord les substrats à une température comprise entre environ 1120°C et environ 1180°C en atmosphère d'hydrogène pendant un temps déterminé, et fait ensuite croître sur lesdits substrats, de la façon bien connue, la couche épitaxiale à une température comprise entre environ 1000 et environ 1100°C en utilisant du tétrachlorure de silicium comme matériau de source pour le silicium.

2. Procédé selon la revendication 1, caractérisé en ce que le processus de chauffage dure environ de 4 à 35 minutes.

3. Procédé selon la revendication 1 ou 2, caractérisé en ce que le chauffage est effectué à une température d'environ 1150°C et que le dépôt est effectué à une température d'environ 1050°C.

4. Procédé selon l'une quelconque ou plusieurs des revendications 1 à 3, caractérisé en ce que l'on fait croître la couche épitaxiale à une vitesse comprise entre environ 0,05 et environ 0,2 mm/minute.

5. Procédé selon l'une quelconque ou plusieurs des revendications 1 à 4, caractérisé en ce que l'on utilise de l'hydrogène comme gaz porteur pour le tétrachlorure de silicium, et que la vitesse linéaire du flux de gaz de $SiCl_4/H_2$ dans le réacteur est supérieure à environ 10 cm/seconde.

6. Procédé selon l'une quelconque ou plusieurs des revendications 1 à 5, caractérisé en ce que l'on fait croître la couche épitaxiale sur un substrat ayant des régions du type $N^+$ avec une concentration de surface supérieure à environ $1 \times 10^{20}$ atomes d'impuretés/$cm^3$.

7. Procédé selon la revendication 6, caractérisé en ce que la croissance s'effectue sur un substrat ayant des régions dopées avec de l'arsenic.

8. Procédé selon l'une quelconque ou plusieurs des revendications 1 à 7, caractérisé en ce que l'on ajoute au mélange de gaz utilisé pour la croissance un matériau contenant de l'arsenic.

9

FIG. 1

FIG. 2

FIG. 3

FIG. 4